# EUROPEAN PATENT APPLICATION

(11) **EP 3 671 711 A1**
(43) Date of publication of application: **24.06.2020**
(21) Application number: 18214746.2
(22) Date of filing: 20.12.2018
(51) Int. Cl.: G09G 3/3225, G06F 3/042, G06K 9/00

(54) **CROSS-TALK REDUCTION IN DISPLAY WITH OPTICAL SCANNER**

(71) Applicant: IMEC vzw, 3001 Leuven (BE)
(72) Inventor: STEUDEL, Soeren, 3001 Leuven (BE); CHEYNS, David, 3001 Leuven (BE); GENOE, Jan, 3001 Leuven (BE); MALINOWSKI, Pawel, 3001 Leuven (BE)
(74) Representative: AWA Sweden AB

(57) **Abstract**

A display (100) of an active matrix thin film emitter LED type is provided, including a substrate (110), a plurality of pixels (120) of a thin film emitter LED type arranged separated from each other on the substrate, a plurality of thin film photodetectors (130) arranged between the pixels, an encapsulation layer (140) covering the pixels and photodetectors, one or more diaphragms (150) of a visible-light-absorbing material, provided on the encapsulation layer and including a plurality of apertures (152) each centered over a respective one of the photodetectors, and at least one cover layer (160) transparent to visible light and provided on the encapsulation layer and the one or more diaphragms. Methods of operating and manufacturing of such a display are also provided.

## Description

### Technical field

The present disclosure relates to the field of displays and optical scanners. More specifically, the present disclosure relates to the integration of such an optical scanner within a display of an active matrix thin film emitter LED type.

### Background

By integrating optical detectors (such as photodiodes) among the pixels in a display, the display may be modified to function both as an image display device and as an optical scanner. Attempts have been made both for LCD displays and AMOLED displays. By allowing light emitted by the pixels of the display to reflect of an object (such as for example a finger of a user) positioned on the display, and by detecting the reflected light using the optical detectors, an image of the object may be generated. Further analysis of the generated image may for example allow the display to function as a fingerprint sensor, and allow for e.g. the unlocking of a phone by the user simply putting one or more fingers on the display.

To protect the display from scratching or other physical forces, it may be required for the display to include at least one outer protective layer (such as a layer of protective glass). Other layers, used e.g. for touch sensing or polarization, may also be required, and the combined thickness of these additional layers may negatively influence the performance of the display as an optical scanner.

In addition, the integration of the photodetectors may require alteration of existing methods of display manufacturing, leading to both increased complexity and increased cost.

Based on the above, there is therefore a need for an improved way of integrating an optical scanner within a display.

### Summary

To at least partly fulfill the above needs, the present disclosure seeks to provide an improved display, an improved method of operating a display, and an improved method of manufacturing a display as defined in the independent claims. Further embodiments of the display and methods are defined in the dependent claims.

According to a first aspect of the present disclosure, a display is provided. The display may include a substrate. The display may include a plurality of pixels arranged separated from each other on the substrate. The display may be of an active matrix thin film emitter LED (*light emitting diode*) type, and the pixels may be of a corresponding type. Examples of displays/pixels may include: organic LEDs (OLEDs) as used in e.g. Active Matrix OLED displays (AMOLED displays); perovskite LEDs (PeLEDs) as used in e.g. Active Matrix PeLED displays (AMPeLED displays); and quantum dot LEDs (QLEDs, or QD-LEDs) as used in e.g. Active Matrix electro-emissive or electroluminescent QD-LED displays (AMQLED displays).

The display may include a plurality of thin film photodetectors/photodiodes, sensitive to light in for example the range from approximately 380 to 1000 nm (including the visible range and part of the lower near-infrared range) and configured to e.g. provide a signal indicative of the amount of light falling on the detector and/or at least a signal indicative of whether light falls on the detector in question or not. The photodetectors may for example be organic photodetectors (OPDs). It is also envisaged to use other thin film photodetectors, based on for example quantum dots, perovskite, and/or amorphous silicon. The photodetectors may be arranged between the plurality of pixels. Here, "between" does not necessarily mean that the photodetectors and the pixels are all arranged within a same plane. Instead, the pixels and the photodetectors may for example be arranged in different planes, but such that the OPDs (if arranged in a plane closer to e.g. a viewer of the display) does not block the pixels for the viewer. The display may include an encapsulation layer which may cover the plurality of pixels and the plurality of photodetectors (and protect e.g. the often sensitive pixels from moisture or other ambient influences). The display may include one or more diaphragms of a visible-light-absorbing material. Within the present disclosure, "visible light" is intended to include light within the range from approximately 380 to 1000 nm, i.e. the visible range and also a part of the lower near-infrared range. The one or more diaphragms may be arranged/provided on the encapsulation layer, and include a plurality of apertures each centered over a respective one of the plurality of photodetectors. Here, a "diaphragm" may be interpreted as an object which covers an area and blocks light from passing therethrough, except through an opening provided by the aperture. It is envisaged that multiple diaphragms may be provided, each providing such coverage/shielding for a respective photodetector. It is envisaged also that only one or a few diaphragms are used, but where a diaphragm then includes multiple apertures such that a single diaphragm may provide such coverage/shielding for more than one photodetector. The display may further include at least one cover layer. The at least one cover layer (e.g. a protective glass layer) may be transparent to visible light and provided on the encapsulation layer and the one or more diaphragms.

By integrating the photodetectors between the pixels of the display, the display may work both to emit light (to display an image) and as an optical scanner (to capture an image of an object positioned on the display). For example, the photodetectors may provide fingerprint sensor functionality to the display. This may allow for the display to function as a fingerprint sensor which may be used to e.g. unlock a phone or similar in which the display is used. Light emitted by the pixels may for example be reflected from the object (e.g. a finger) positioned on the display, and the reflected light may be detected and recorded by the photodetectors.

The at least one cover layer may be used to e.g. protect the display from e.g. scratches or physical impact, and/or to work as a polarizer, and/or e.g. to provide touch sensing if the display is a touch sensitive display where a user may use e.g. a stylus or a finger in order to perform various movements and/or clicks on the display. The thickness of the at least one cover layer may for example be between 0.1 to 1 mm, and may correspond to a multiple of the pitch of (i.e. separation between) the pixels. Such a thickness may however introduce optical cross-talk within the display, wherein the detection of reflected light by a certain photodetector is influenced not only by light originating only from the nearest neighboring pixels, but also by light originating from pixels further away. Such optical cross-talk may blur an image recorded by the photodetectors, and/or provide e.g. an unwanted reduction in the resolution of the image.

By providing the one or more diaphragms on the encapsulation layer, the light received by each photodetector may be "coned". Phrased differently, the one or more diaphragms may help to reduce the impact of optical cross-talk by blocking light from more distant pixels (i.e. light having a different incoming angle than light from nearest neighboring pixels). In other words, the one or more diaphragms may help to reduce the acceptance angle of the light cone which reaches the photodetector, so that light emitted by pixels adjacent to a certain photodetector is captured preferentially over light originating from any other pixel after reflection on the object (e.g. a finger, placed on the display) which is to be scanned. In addition, a display according to the present disclosure may be manufactured using a process which still conforms well with existing processes of manufacturing displays of the active matrix thin film emitter LED type. For example, by providing the one or more diaphragms on top of the encapsulation layer, and not e.g. within the encapsulation layer and/or directly on the photodetectors themselves, the one or more diaphragms may be provided without damaging the photodetectors and/or the pixels (such as e.g. AMOLED pixels), as the already provided encapsulation layer may protect the photodetectors and the pixels. The one or more diaphragms may for example be added as a color filter resist, in a similar process already used during production of TV screens.

In some embodiments, the display may further include a controller. The controller may be configured for controlling (including at least switching on and off) the plurality of pixels and to receive data from the plurality of photodetectors. The controller may further be configured to perform at least the following steps: (a) switching off the pixels located within an area corresponding to a presence of an object (such as a finger) positioned on the display; (b) switching on only a first true subset (i.e. a number less than the full number) of the pixels within the area; (c) recording a first image frame by measuring, using one or more of the photodetectors within the area, photodetector data of reflected light from the first true subset of pixels within the area; (d) repeating at least steps (b) and (c) for at least one additional, different (i.e. for at least some pixels different from the previous ones) true subset of the pixels within the area to create at least one additional image frame which together with the first image frame forms a plurality of image frames; and (e) creating an object of the image positioned on the display by combining the plurality of image frames.

The steps (i.e. scanning technique) performed by the controller may help to further increase a difference in signal strength between the signal detected from pixel reflection from the same pixel versus neighboring pixels. This may e.g. remove a base signal from more distant pixels which may be present even after the addition of the one or more diaphragms as described above, and help to further reduce the impact of the above mentioned optical cross-talk and negative effects originating from the presence of the at least one cover layer. More details regarding the scanning technique will be given further below.

In some embodiments, the controller may be further configured to, in step (b), select the first true subset of the pixels within the area such that the switched on pixels are separated by a threshold distance.

In some embodiments, the threshold distance may be given as a function of a combined thickness of the at least one cover layer divided by a pixel pitch of the plurality of pixels.

In some embodiments, the threshold distance may correspond to a distance between every n:th pixel, where n is given by the combined thickness (of the at least one cover layer) divided by the product of the pixel pitch and a value between 1 to 5. Written as a mathematical equation, the threshold distance (which may define the size of the above area) may be proportional to "the combined thickness of the at least one cover layer" divided by "*n* times the pixel pitch", where n is a (integer) value between 1 to 5. Examples of such a strategy will be described later herein with reference to exemplary embodiments.

In some embodiments, the plurality of pixels may include pixels of at least two colors. The controller may be configured to perform the steps (a) to (e) such that a set of the plurality of image frames is created for each color. This may result in e.g. a doubling of the number of necessary scans. However, the absorption of different colors in e.g. a finger may be different, and the resulting different sets of image frames may provide additional details which may, for example, provide additional security features.

In some embodiments, the at least two colors may include red and green. The absorption of red and green in e.g. a finger may for example be strongly influenced by the oxygen content of the blood in the finger.

In some embodiments, the display may further include means for detecting the presence of the object positioned on an area of the display. The object may preferably be a finger, or other digit, of a user of the display. The means for detecting the presence of the object may for example use capacitive sensing, or other suitable techniques.

In some embodiments, the combining of the plurality of image frames may include weighing photodetector data in each image frame together based on distances between the measuring one or more photodetectors within the area and the switched on pixels within the area.

In some embodiments, the light-absorbing material (used in the one or more diaphragm) may include a black matrix resist.

In some embodiments, the one or more diaphragms may be ring-shaped. It is envisaged also to use other suitable shapes providing at least one aperture therein.

In some embodiments, the at least one encapsulation layer may have a thickness between 1 µm to 50 µm.

In some embodiments, the display may include an additional encapsulation layer. The additional encapsulation layer may be provided between the plurality of pixels and the plurality of photodetectors, such that the plurality of photodetectors is arranged further from the substrate (e.g. in a separate plane/layer) than the plurality of pixels. Such an arrangement may provide the same benefits as discussed above, but e.g. separate some of the design challenges of driving e.g. an OPD and an emitter (pixel) in a same array. Such an arrangement may for example also be implemented within an LCD display.

According to a second aspect of the present disclosure, a method of operating a display (of an active matrix thin film emitter LED type, such as the display described herein with reference to the first aspect) is provided. The display may include a plurality of pixels (of a thin film emitter LED type) arranged separated on a substrate, a plurality of thin film photodetectors/photodiodes (working at least in the optical range) arranged between the plurality of pixels (wherein the term "between" is to be interpreted as described earlier herein), an encapsulation layer covering the plurality of pixels and the plurality of photodetectors, one or more diaphragms of a visible-light-absorbing material provided on the encapsulation layer and including a plurality of apertures each centered over a respective one of the plurality of photodetectors, and at least one cover layer transparent to visible light and provided on the encapsulation layer and the one or more diaphragms. The method may include: (a) switching off the pixels located within an area corresponding to a presence of an object (such as e.g. a finger) positioned on the display; (b) switching on only a first true subset of the pixels within the area; (c) recording a first image frame by measuring, using one or more of the photodetectors within the area, photodetector data of reflected light from the first true subset of the pixels within the area; (d) repeating at least steps (b) and (c) for at least one additional, different true subset of the pixels within the area to create at least one additional image frame which together with the first image frame forms a plurality of image frames; and (e) creating an image of the object positioned on the display by combining the plurality of image frames.

According to a third aspect of the present disclosure, a method of manufacturing a display (of an active matrix thin film emitter LED type, such as the display described above with reference to the first aspect). The method may include: providing a plurality of pixels (of a thin film emitter LED type) and a plurality of thin film photodetectors on a substrate (not necessarily all in a same layer or plane), such that the plurality of pixels are separated from each other and such that the plurality of photodetectors are provided between the plurality of pixels (where, once again, "between" is to be interpreted as described earlier herein); providing an encapsulation layer covering the plurality of pixels and the plurality of photodetectors; providing one or more diaphragms of a visible-light-absorbing material on the encapsulation layer, including a plurality of apertures each centered over a respective one of the plurality of photodetectors; and providing at least one cover layer on the encapsulation layer and the one or more diaphragms.

Such a method of manufacturing may be beneficial in that it conforms well with already existing methods for the manufacturing of normal displays (without the photodetectors), especially displays of the above mentioned active matrix thin film emitter LED type (such as e.g. AMOLED displays).

The present disclosure relates to all possible combinations of features mentioned herein, including the ones listed above as well as other features which will be described in what follows with reference to different embodiments. Any embodiment described herein may be combinable with other embodiments also described herein, and the present disclosure relates also to all such combinations. For example, all limitations specified herein with reference to the display according to the first aspect may apply also to (and/or be combinable with) one or both of the methods according to the second and third aspects, and vice versa. Further objects and advantages of the various embodiments of the present disclosure will be described below by means of exemplifying embodiments.

### Brief description of the drawings

Exemplifying embodiments will be described below with reference to the accompanying drawings, in which:
Figure 1a schematically illustrates a cross-section of an embodiment of a display according to the present disclosure;
Figure 1b schematically illustrates a cross-section and the workings of an embodiment of a display according to the present disclosure;
Figure 2 schematically illustrates a cross-section of an embodiment of a display according to the present disclosure;
Figure 3 schematically illustrates a top-view of an embodiment of a display according to the present disclosure; and
Figures 4a-4c schematically illustrates steps of an embodiment of a method of operating a display according to the present disclosure.

In the drawings, like reference numerals will be used for like elements unless stated otherwise. Unless explicitly stated to the contrary, the drawings show only such elements that are necessary to illustrate the example embodiments, while other elements, in the interest of clarity, may be omitted or merely suggested. As illustrated in the figures, the sizes of elements and features may be exaggerated for illustrative purposes and, thus, are provided to illustrate the general structures of the embodiments.

### Detailed description

Exemplifying embodiments of a display and various methods according to the present disclosure will now be described more fully hereinafter with reference to the accompanying drawings. The drawings show currently preferred embodiments, but the invention may, however, be embodied in many different forms and should not be construed as limited to the embodiments set forth herein; rather, these embodiments are provided for thoroughness and completeness, and fully convey the scope of the present disclosure to the skilled person.

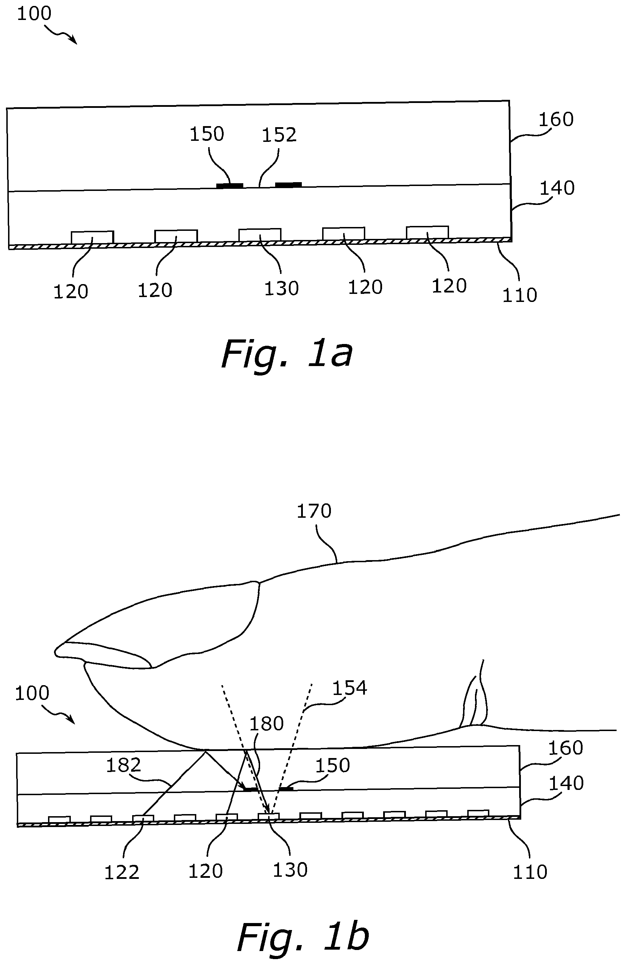

With reference to Figures 1a, 1b, 2 and 3, various embodiments of a display according to the present disclosure will now be described in more detail.

Figure 1a illustrates schematically a cross-section of an embodiment of a display 100. The display includes a substrate 110, on which a plurality of pixels (e.g. AMOLED pixels or other thin film emitter LED based pixels) 120 are provided. The pixels 120 are separated from each other, and a plurality of photodetectors in the form of organic photodetectors (OPDs) 130 (only one OPD is shown in Figure 1a) are arranged between the pixels 120. Although the embodiments described herein with reference to the drawings will include such OPDs, it is envisaged that other embodiments of a display according to the present disclosure may use other forms of thin film photodetectors than OPDs may be used, such as for example those based on quantum dots, perovskite and/or amorphous silicon. In the display 100 as illustrated in Figure 1a, the pixels 120 and the OPDs 130 are provided in a same layer of the display. To encapsulate the pixels 120 and the OPDs 130, the display 100 includes an encapsulation layer 140 provided on the pixels 120 and the OPDs 130. To further protect the display 100, a cover layer in the form of a scratch resistance glass layer 160 is provided on the encapsulation layer 140.

A diaphragm 150 is provided on the encapsulation layer 140 (and also enclosed by the cover layer 160). The diaphragm 150 has an aperture 152 which is centered with respect to the OPD 130, such that light may pass through the aperture 152 on its way towards the OPD 130. The pixels 120 may have different colors (such as red, blue and green) or be of a same color, depending on the exact purpose of the display. If multiple colors are used, it may be envisaged that the pixels 120 are arranged in a repeating pattern of different colors, and that an OPD 130 is e.g. inserted between the pixels 120 every n:th pixel. It may, for example, be envisaged that the two pixels 120 to the left (as illustrated in Figure 1a) of the OPD 130 are e.g. red and green pixels, and that the first pixel 120 to the right of the OPD 130 is a blue pixel. The pixel 120 furthest to the right may then be another red pixel belonging to the next iteration of groups of pixels. Other suitable arrangements of pixels and OPDs may also be envisaged. The pixels 120 may for example not produce light of their own, but rather include color filters which uses e.g. a common white light as light source (such as in e.g. AMOLED television sets). In any way, such color filters in combination with a common light source is still referred to as "pixels" within the meaning of the present disclosure.

The display 100 may also include a controller (not shown), which may be connected to the plurality of pixels 120 and OPDs 130. The controller may for example be configured to turn specific pixels on and off, and to receive and record data from the OPDs.

Figure 1b further illustrates the functioning of the display 100, and illustrates schematically a cross-section of a larger part of the display 100. An object in the form of a finger 170 is positioned on the display 100, on the cover layer 160. It should be noted that the finger 170 is for illustrative purpose only, and not necessarily drawn to scale with respect to the size and spacing of the various layers, pixels and OPDs.

When recording data for light reflected from the finger 170, the OPD 130 may receive reflected light originating both from nearest neighboring pixels such as the pixel 120, and from pixels further away such as the pixel 122. The diaphragm 150 may restrict the allowed angles of incident light on the OPD 130, such that light from nearest neighboring pixels are preferred over light originating from more distant pixels. This is illustrated in Figure 1b by the light beams 180 and 182, where the light beam 180 originating from the nearby pixel 120 is allowed to reach the OPD 130 while the light beam 182 originating from the more distant pixel 122 is blocked by the diaphragm 150. Phrased differently, the diaphragm 150 and corresponding aperture defines a cone 154, such that light beams having incident angles which fit within this cone 154 are allowed to reach the OPD 130, while light beams having incident angles outside of the cone 154 are blocked by the diaphragm 150.

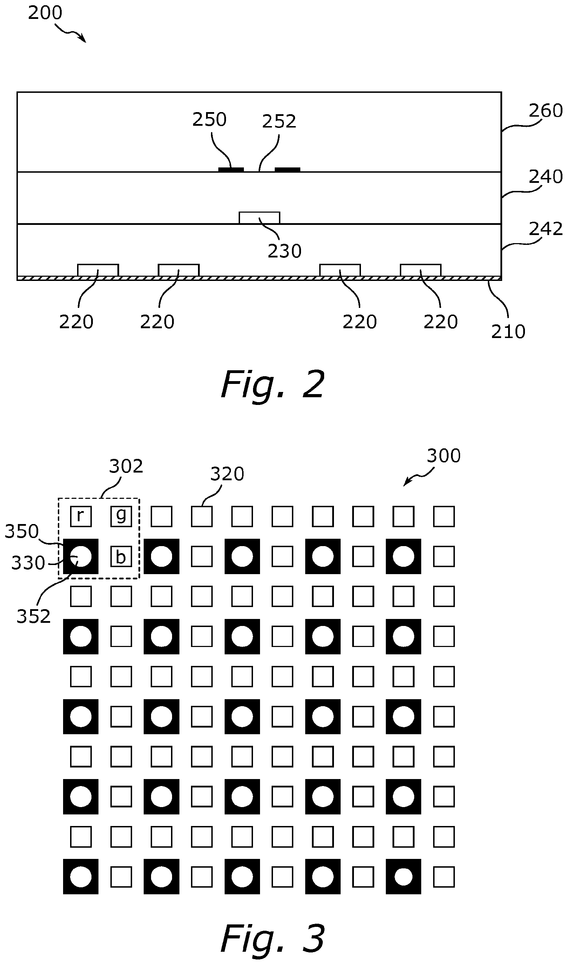

Figure 2 illustrates schematically a cross-section of another embodiment of a display 200. The display 200 includes a substrate 210. In this embodiment, in contrast to the display 100 described with reference to Figure 1a, the pixels 220 and OPDs 230 are provided in separate layers. In addition to the encapsulation layer 240 (which covers the OPDs 230), an additional encapsulation layer 242 is provided between the OPDs 230 and the pixels 230. It may be envisaged that the encapsulation layer 240 and the additional encapsulation layer 242 form part of a single encapsulation layer. The diaphragms 250 are provided on the encapsulation layer 240, above the OPDs 230, where the apertures 152 of the diaphragms 150 are as before centered above a respective OPD 230. If seen from above, i.e. from an angle normal to the extension plane of the substrate 210, the OPDs 230 are still arranged between the pixels 220. The display 200 and the configuration of the pixels 220 and OPDs 230 in different layers may still address the same challenges as e.g. the display 100 described with reference to Figure 1a. However, the separation of the pixels 220 and OPDs 230 into separate layers may for example separate some of the design challenges of e.g. driving of OPDs and pixels in a same array. It is envisaged also that the configuration of the display 200 shown in Figure 2 may also be implemented with an LCD display.

Figure 3 illustrates schematically an embodiment of a display 300 viewed from above. The display 300 includes a substrate (not shown), on which a plurality of pixels 320 and a plurality of OPDs 330 are arranged. The pixels 320 are arranged separated from each other, and the OPDs 330 are arranged between the pixels 320. In the display 300, three pixels (here marked with "r", "g" and "b", corresponding to a red, green and blue pixel, respectively) and one OPD 330 together define a unit cell 302. The unit cell 302 is repeated to form a full pattern of repeating pixels and OPDs, as shown in Figure 3. In each unit cell 302, a diaphragm 350 with an aperture 352 is provided above, and with the aperture 352 centered around, each OPD 330. Other configurations of pixels and OPDs, with corresponding diaphragms, are also envisaged.

As described earlier herein, all of the displays 100, 200 and 300 as described with reference to Figures 1a, 1b, 2 and 3 may include also a controller (not shown) connected to the pixels and OPDs, such that the pixels may individually be switched on and off, and such that data from the OPDs may be received, recorded and processed as needed.

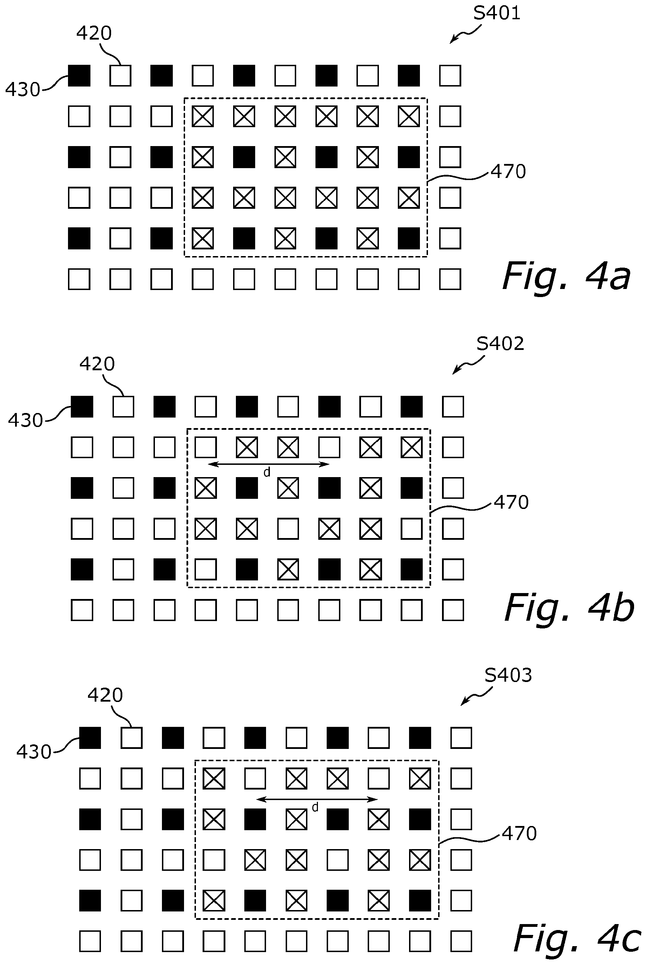

With reference to Figures 4a to 4c, an embodiment of a method of operating a display (such as the displays described above) will now be described in more detail.

Figure 4a displays a method step S401, wherein, on a display including a plurality of pixels 420 and OPDs 430 (arranged as described earlier herein), the presence of an object (e.g. a finger) has been detected in an area 470 of the display. In the step S401, the pixels 420 located within the area 470 are switched off, as indicated by the crosses in the boxes representing the pixels 420. The diaphragms are not shown, and the OPDs are represented by the fully filled boxes 430. It should be noted that the example as will be described with reference to Figures 4a to 4c is only for illustrative purposes, and that e.g. the size/number of pixels with respect to a likely area of e.g. a finger may be different in a real world example.

Figure 4b displays a next step S402, wherein a subset of the pixels is switched on. In the embodiment shown in Figure 4b, the switched on pixels in the subset is selected such that they are all separated by approximately the threshold distance d. As described earlier herein, the distance d may for example depend on the thickness of a (protective) cover layer which is present on top of the display, and on a pixel pitch (i.e. a separation between individual pixels) of the display. In the example illustrated in Figure 4b, the size of the distance d is approximately equal to the distance between 4 pixels, i.e. three times the pixel pitch. A more real world example may include e.g. a 500 µm thick cover glass (cover layer), and a 50 µm pixel pitch. The pixels in each subset may then be selected such that e.g. every 5th or 10th pixel is switched on simultaneously. More generally, it is envisaged that the separation of pixels which are switched on in each true subset may be selected using e.g. the formula "the thickness of transparent cover/top/protective layers" divided by "n times the pixel pitch", where n is an integer between e.g. 1 to 5. In the given example resulting in every 5th or 10th pixel being switched on, the integer n was then selected to be n=2 or n=1, respectively.

It is envisaged also that the subset of pixels which are switched on may be selected using different techniques.

In the step S402, light from the activated/switched on pixel(s) is recorded by the OPDs within the area 470. Phrased differently, only a true subset of all pixels within the area 470 is switched on, and OPD data of reflected light from this true subset of pixels within the area 470 is recorded by the OPDs within the area 470. As described earlier herein, a "true" subset means that the subset does not include all of the pixels within the area 470. The OPD data recorded by the OPDs within the area 470 is used to construct/record a first image frame.

Figure 4c displays a next step S403, wherein a different subset of the pixels within the area is switched on. The different subset of the pixels within the area as illustrated in Figure 4b is here selected by switching on a pixel neighboring a previously switched on pixel, but such that the switched on pixels are still separated approximately by the distance d. The OPDs within the area 470 then records new OPD data in order to construct/record a second image frame.

It is envisaged that the method may then continue by, step by step and in a similar way, switching on (and off) pixels, by selecting new true subsets of pixels, within the area 470until e.g. all pixels in the area 470 have been switched on at least once. For each step, an additional image frame may be constructed/recorded and a plurality of image frames may be formed.

In other embodiments, and as described above, it may be envisaged to increase the distance between switched on pixels. For example, the distance may be increased such that e.g. only every 5th or 10th pixel is switched on during each repetition/step. As the distance between the pixels that are switched on increases, the elimination of shallower rays may be improved. At a same time, increasing the distance between switched on pixels may provide a slower scanning and higher computational requirements in order to obtain all image frames, assuming that all pixels within the area 470 are to be turned on at least once before the method finishes.

In other embodiments, different strategies for switching on and off pixels may be used. For example, using an area having 6x6 pixels arranged in a rectangular pattern may include first turning on every 3rd pixel in every 3rd row. This would include first turning on e.g. pixels 1 and 4 in each of row 1 and 4. For the next image frame, the switched on pixels may be moved row wise, such that now pixels 2 and 5 still in each of row 1 and 4 are switched on instead. In a next image frame, the switched on pixels may be pixels 3 and 6 still in each of row 1 and 4, such that all pixels in each of row 1 and 4 have now been turned on once. This process may then repeat for the remaining rows, by first turning on pixels 1 and 4 in each of rows 2 and 5, etc., and end with turning on pixels 4 and 6 in each of rows 4 and 6. A total of 9 image frames would need to be captured before each pixel in the area has been turned on once.

If instead turning on e.g. every 2nd pixel in every 2nd row, only 4 image frames would need to be captured before each pixel in the area has been turned on once. This would, although faster, not provide the same improvement with regards to eliminating shallow light rays compared to the example wherein only every 3rd pixel in every 3^{rd} row is switched on simultaneously. Likewise, turning on every 6th pixel in every 6th row (corresponding to only turning on a single pixel within the area at once) would require a total of 36 image frames to be recorded, but allow for an even further improvement in the elimination of shallow rays.

Once all of the image frames have been obtained, the method may proceed by creating an image of the object positioned on the display (e.g. a fingerprint image) by combining the plurality of image frames obtained during the various iterations. The combination of image frames may for example include weighing of each image frame data depending on a distance from the OPD used to record the data to the pixel or pixels which was/were switched on in the area during the time the OPD recorded that data. Although the proposed method will require the recording of multiple images, the switching on and off of individual pixels may increase a difference in signal strength between light detected from reflection from a same pixel versus more distant pixels, and thereby further reduce the impact of optical cross-talk in the display (when used as an optical scanner).

In other embodiments, it is envisaged that the method may also include taking into account the different colors of different pixels. For example, the method may include to first record images using only green pixels, followed by the creation of same images but with red pixels activated. As described earlier herein, the absorption of red and green light in e.g. a finger may depend strongly on the oxygen content of the blood, and additional security features of the optical scanner may therefore be implemented.

The present disclosure also proposes a method for manufacturing of a display (e.g. a display as described in multiple embodiments herein). Such a method may apply to a display of an active matrix thin film emitter LED type (e.g. an AMOLED display), and may include providing a plurality of pixels of a thin film emitter LED type and a plurality of OPDs on a substrate, such that the pixels are separated from each other and such that the OPDs are arranged between the pixels (at least as seen by a viewer looking at the display from the normal viewing angle). As also described herein, the pixels and OPDs do not necessarily have to lie in the same plane. It is envisaged that the OPDs may be further from the substrate than the pixels, and arranged in their own plane.

After providing the pixels and OPDs on the substrate, the pixels and OPDs may be encapsulated by one or more encapsulation layers. The encapsulation may for example be performed using a thin film encapsulation (TFE) technique such as already used during production of e.g. OLED-based displays. Such a technique may have a limited temperature tolerance/budget (e.g. < 110 °C), in order to avoid damaging the pixels (or OPDs).

To limit the effect of optical cross-talk, the method of the present disclosure proposes to add/provide one or more diaphragms of a visible-light-absorbing material on top of the encapsulation layer, with apertures which are centered above corresponding OPDs. The diaphragms (which may be e.g. of a black matrix resist) may for example be added using a color filter (photoresist) process such as used during OLED TV fabrication for adding color filters on top of a TFE encapsulating a (white) OLED. By providing the diaphragms on top of the encapsulation layer, the proposed method may respect the temperature limitations on the pixels/OPDs, and avoid the risk of damaging the pixels and/or OPDs below the encapsulation layer, especially if the display/pixels are of e.g. AMOLED/OLED type or similar.

Herein, the distance between a diaphragm and corresponding OPD may e.g. be of a same order of magnitude as the pixel pitch. The form and dimensions of the diaphragms, and/or the sizes of the apertures may for example be selected such that the diaphragms do not substantially reduce the display light-emission efficiency. In some embodiments, the diaphragm is preferably such that it absorbs all incoming light (except for the light allowed to pass through the aperture). In other embodiments, the diaphragm may be allowed to reflect at least part of the incoming light.

In summary, the proposed display and methods of operation and manufacturing thereof provide a solution where the effects of optical cross-talk may be reduced, while conforming well with already available processes used for e.g. manufacturing of AMOLED displays. In addition, as the positioning of the diaphragms on top of the encapsulation layer (instead of e.g. directly on the pixels/OPDs) may not be optimal in terms of cross-talk reduction as very shallow rays (of light reflected from pixels far away from the OPD in question, or light reflected internally on e.g. the cover layer) may still be allowed to reach the OPD in question, the proposed method of operating the display, using the scanning technique as described earlier herein, may further compensate for, and reduce the negative impact of, such shallow rays.

Although features and elements are described above in particular combinations, each feature or element may be used alone without the other features and elements or in various combinations with or without other features and elements. The same applies to methods and individual method steps, which may be used alone or in combination also in other order if not explicitly indicated otherwise.

Additionally, variations to the disclosed embodiments can be understood and effected by the skilled person in practicing the claimed invention, from a study of the drawings, the disclosure, and the appended claims. Even if the inventive concept of the present disclosure has mainly been described with reference to a limited number of examples/embodiments, it is readily appreciated by the skilled person that other examples than the ones disclosed above are equally possible within the scope of the inventive concept, as defined by the appended claims.

In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. A display (100) of an active matrix thin film emitter LED type, comprising:
a substrate (110);
a plurality of pixels (120) of a thin film emitter LED type arranged separated from each other on said substrate;
a plurality of thin film photodetectors (130) arranged between said plurality of pixels;
an encapsulation layer (140) covering said plurality of pixels and said plurality of photodetectors;
one or more diaphragms (150) of a visible-light-absorbing material, provided on said encapsulation layer, and including a plurality of apertures (152) each centered over a respective one of said plurality of photodetectors, and
at least one cover layer (160) transparent to visible light and provided on said encapsulation layer and said one or more diaphragms.

2. The display of claim 1, further comprising:
a controller for controlling said plurality of pixels and to receive data from said plurality of photodetectors, and configured to perform the steps of:
a) switching off the pixels located within an area corresponding to a presence of an object positioned on said display;
b) switching on only a first true subset of the pixels within said area;
c) recording a first image frame by measuring, using one or more of the photodetectors within said area, photodetector data of reflected light from said first true subset of the pixels within said area;
d) repeating at least steps b) and c) for at least one additional, different true subset of the pixels within said area to create at least one additional image frame which together with said first image frame forms a plurality of image frames; and
e) creating an image of the object positioned on the display by combining said plurality of image frames.

3. The display of claim 2, wherein the controller is further configured to, in step b), select said first true subset of the pixels within said area such that the switched on pixels are separated by a threshold distance.

4. The display of claim 3, wherein the threshold distance is given as a function of a combined thickness of said at least one cover layer divided by a pixel pitch of said plurality of pixels.

5. The display of claim 4, wherein the threshold distance corresponds to a distance between every n:th pixel, where n is given by said combined thickness divided by the product of said pixel pitch and a value between 1 to 5.

6. The display of any one claims 2 to 5, wherein said plurality of pixels include pixels of at least two colors, and wherein the controller is configured to perform the steps a) to e) such that a set of said plurality of image frames is created for each color.

7. The display of claim 6, wherein said at least two colors includes red and green.

8. The display of any one of the preceding claims, further comprising means for detecting said presence of the object on an area of said display, said object preferably being a finger or other digit of a user of the display.

9. The display of any one of claims 2 to 8, wherein said combining said plurality of image frames includes weighing photodetector data in each image frame together based on distances between the measuring one or more photodetectors within said area and the switched on pixels within said area.

10. The display of any one of the preceding claims, wherein the light-absorbing material includes a black matrix resist.

11. The display of any one of the preceding claims, wherein said one or more diaphragms are ring-shaped.

12. The display of any one of the preceding claims, wherein said at least one encapsulation layer has a thickness between 1 µm to 50 µm.

13. The display of any one of the preceding claims, wherein an additional encapsulation layer is provided between said plurality of pixels and said plurality of photodetectors, such that said plurality of photodetectors is arranged further from the substrate than said plurality of pixels.

14. A method of operating a display of an active matrix thin film emitter LED type including a plurality of pixels of a thin film emitter LED type arranged separated on a substrate, a plurality of thin film photodetectors arranged between said plurality of pixels, an encapsulation layer covering said plurality of pixels and said plurality of photodetectors, one or more diaphragms of a visible-light-absorbing material provided on said encapsulation layer and including a plurality of apertures each centered over a respective one of said plurality of photodetectors, and at least one cover layer transparent to visible light and provided on said encapsulation layer and said one or more diaphragms, said method comprising:
a) switching off the pixels located within an area corresponding to a presence of an object positioned on said display;
b) switching on only a first true subset of the pixels within said area;
c) recording a first image frame by measuring, using one or more of the photodetectors within said area, photodetector data of reflected light from said first true subset of the pixels within said area;
d) repeating at least steps b) and c) for at least one additional, different true subset of the pixels within said area to create at least one additional image frame which together with said first image frame forms a plurality of image frames; and
e) creating an image of said object positioned on the display by combining said plurality of image frames.

15. A method of manufacturing a display of an active matrix thin film emitter LED type, comprising the steps of:
providing a plurality of pixels of a thin film emitter LED type and a plurality of thin film photodetectors on a substrate, such that said plurality of pixels are separated from each other and such that said plurality of photodetectors are provided between said plurality of pixels;
providing an encapsulation layer covering said plurality of pixels and said plurality of photodetectors;
providing one or more diaphragms of a visible-light-absorbing material on said encapsulation layer, including a plurality of apertures each centered over a respective one of said plurality of photodetectors; and
providing at least one cover layer on said encapsulation layer and on said one or more diaphragms.
